# EUROPÄISCHE PATENTSCHRIFT

(11) **EP 3 087 439 B1**
(45) Veröffentlichungstag und Bekanntmachung des Hinweises auf die Patenterteilung: **31.01.2018**
(21) Anmeldenummer: 14798891.9
(22) Anmeldetag: 17.11.2014
(51) Int. Cl.: G05B 23/02, G01D 18/00, G01D 21/00, G01R 31/28, H04B 17/17, G05B 19/042, G01D 5/14, G01R 35/00

(54) **MESSUMFORMER MIT ÜBERWACHUNGSFUNKTION**
MEASUREMENT TRANSDUCER HAVING A MONITORING FUNCTION
TRANSDUCTEUR DE MESURE DOTÉ D'UNE FONCTION DE SURVEILLANCE

(30) Priorität: 23.12.2013 DE 102013021780; 17.02.2014 DE 102014101945
(43) Veröffentlichungstag der Anmeldung: 02.11.2016
(73) Patentinhaber: Endress + Hauser GmbH + Co. KG, 79689 Maulburg (DE)
(72) Erfinder: GIRARDEY, Romuald, F-68730 Blotzheim (FR); STIB, Ralph, 79677 Schönau (DE); SAUTERMEISTER, Manuel, 79585 Steinen (DE); KARWECK, Lars, 79589 Binzen (DE); SPITZ, Andreas, 79650 Schopfheim (DE); ZIERINGER, Thomas, 79650 Schopfheim (DE)
(74) Vertreter: Andres, Angelika Maria
(86) Internationale Anmeldenummer: PCT/EP2014/074714
(87) Internationale Veröffentlichungsnummer: WO 2015/096933

(56) Entgegenhaltungen:
- EP-A2- 2 613 463
- DE-A1-102007 022 991
- DE-A1-102009 050 645
- US-A1- 2005 168 343
- US-A1- 2013 325 381

## Beschreibung

Die vorliegende Erfindung betrifft einen Messumformer mit Überwachungsfunktion, insbesondere einen Messumformer der industriellen Prozessmesstechnik mit einer Überwachungsfunktion. Messumformer der industriellen Prozessmesstechnik werden gewöhnlich in Prozessleitsystemen eingesetzt, um Messgrößen wie Druck, Durchfluss, Füllstand, Temperatur und Stoffparameter wie pH, Leitfähigkeit, Zähigkeit, Dichte, Feuchte, Anteil an gelöstem Gas, oder Mischungsverhältnis von Komponenten zu messen, und einen die Messgröße repräsentierenden Messwert auszugeben. Insbesondere in sicherheitskritischen Anwendungen werden erhöhte Anforderungen daran gestellt, dass die Funktion des Messumformers überwacht ist, so dass ein Fehler des Messumformers nicht unbemerkt bleibt. Hierzu gehört beispielsweise die Zertifizierung von Messumformern nach dem so genannten SIL-Standard der internationalen Norm IEC 61508 zur funktionalen Sicherheit. Überwachungskonzepte für Messumformer sind beispielsweise in EP 2 613 463 A2, WO 2005/017851 A1, WO 03/060851 A1 und EP 1 697 803 B1 beschrieben.

Für die Erreichung von SIL 2 werden in der Regel für eine möglichst hohe Fehlererkennung und Anteil so genannter sicherer Ausfälle (SFF nach dem englischen Safe Failure Fraction) Diagnosemaßnahmen in Form von redundanter Hardware eingesetzt. So befindet sich beispielsweise eine weitere Logikeinheit zur Überwachung der Hauptelektronik im Transmitter.

Durch die zusätzlichen Bauteile für die redundante Diagnose fallen zusätzliche Produktionskosten sowie ein erhöhter Platzbedarf an. Ebenfalls benötigt jedes zusätzliche Bauteil elektrische Leistung, was insbesondere bei Zweidraht HART-Schnittstellen, bei denen die zur Verfügung stehende Leistung begrenzt ist, kritisch sein kann.

Es ist daher die Aufgabe der vorliegenden Erfindung, einen Messumformer bereitzustellen, welcher eine Überwachung seiner Funktionen mit geringerem Aufwand als der Stand der Technik realisieren kann.

Die Aufgabe wird erfindungsgemäß gelöst durch den Messumformer gemäß dem unabhängigen Patentanspruch 1.

Der erfindungsgemäße Messumformer umfasst ein Sensormodul, welches mindestens einen Sensor und eine Sensorelektronik aufweist, wobei der Sensor Sensorsignale ausgibt, und wobei die Sensorelektronik die digitalisierten Sensorsignale mit einer Übertragungsfunktion aufbereitet und aufbereitete Sensor-Messwerte an einer digitalen Schnittstelle bereitstellt; und ein Hauptelektronikmodul, welches mit der Sensorelektronik funktionell verbunden ist, wobei das Hauptelektronikmodul eine Logikeinheit beispielsweise einen Mikrokontroller und eine Kommunikationsschnittstelle aufweist, wobei die Logikeinheit dazu eingerichtet ist, die an der digitalen Schnittstelle bereitgestellten Sensor-Messwerte zu empfangen und die Ausgabe eines Messsignals, welches den Sensor-Messwerten entspricht durch die Kommunikationsschnittstelle zu veranlassen, wobei die Logikeinheit dazu eingerichtet ist, eine Überwachungsfunktion auszuführen wobei die Überwachungsfunktion umfasst, zusätzlich zu einem aktuell bereitgestellten Sensor-Messwert die zugehörigen digitalisierten Sensorsignale zu empfangen, anhand einer Testfunktion, welche die Übertragungsfunktion umfasst, und anhand der empfangenen zugehörigen digitalisierten Sensorsignale einen Kontroll-Messwert zu berechnen, und einen Vergleich zwischen dem Kontroll-Messwert und dem Sensor-Messwert durchzuführen, und bei Abweichungen die Kommunikationsschnittstelle zu veranlassen, ein Fehlersignal auszugeben, wobei die Logikeinheit weiter dazu eingerichtet ist den Kontroll-Messwert der Sensorelektronik bereitzustellen, wobei die Sensorelektronik dazu eingerichtet ist, einen Vergleich zwischen dem Kontroll-Messwert und dem Sensor-Messwert durchzuführen, und bei Abweichungen die Kommunikationsschnittstelle direkt zu veranlassen, ein Fehlersignal auszugeben.

Die Kommunikationsschnittstelle kann insbesondere einen Stromausgang umfassen, wobei das Fehlersignal einen Fehlerstrom kleiner 4 mA oder größer 20 mA umfassen kann.

In einer Weiterbildung der Erfindung umfasst die Übertragungsfunktion einen Algorithmus, der dazu eingerichtet ist, Querempfindlichkeiten des Sensors auf Störgrößen zu kompensieren und/oder eine lineare Sensor-Messwert-Funktion bereitzustellen.

In einer Weiterbildung der Erfindung umfasst die Testfunktion einen Testalgorithmus, der zusätzlich zu einer Implementierung der Übertragungsfunktion noch weitere Schritte enthält, wobei der Testalgorithmus zu jedem weiteren Schritt den inversen Schritt umfasst, so dass der Kontroll-Messwert durch die weiteren Schritte bei korrekter Ablauf des Testalgorithmus und bei korrekter Funktion des Mikroprozessors im Ergebnis nicht verändert wird.

In einer Weiterbildung der Erfindung umfassen die weiteren Schritte arithmetische Operationen, jeweils in Kombination mit dieser inversen Operation umfassen, insbesondere Addition und Subtraktion, Multiplikation und Division.

In einer Weiterbildung der Erfindung umfassen die weiteren Schritte Verweise bzw. Sprünge aus dem Algorithmus der Übertragungsfunktion heraus und zurück.

In einer Weiterbildung der Erfindung ist die Sensorelektronik dazu eingerichtet, die Sensor-Messwerte mit einer definierten Ausgaberate an der digitalen Schnittstelle bereitzustellen, wobei die Logikeinheit dazu eingerichtet ist zu überwachen, ob die Ausgaberaten eingehalten wird, und die Kommunikationsschnittstelle zu veranlassen, ein Fehlersignal auszugeben, wenn dies nicht der Fall ist.

In einer Weiterbildung der Erfindung ist die Überwachungsfunktion in definierten zeitlichen Abständen durchzuführen, wobei die Durchführung der Überwachungsfunktion insbesondere durch die Logikeinheit zu initiieren ist, wobei die Sensorelektronik überwacht, ob der zeitliche Abstand zum Initiieren der Überwachungsfunktion eingehalten wird.

In einer Weiterbildung der Erfindung ist die Logikeinheit dazu eingerichtet, den Kontroll-Messwert innerhalb einer vorgegebenen Bearbeitungszeit nach dem Empfang der digitalisierten Sensorsignale bereitzustellen, wobei die Sensorelektronik dazu eingerichtet ist zu überwachen, ob die vorgegebene Bearbeitungszeit eingehalten wird.

In einer Weiterbildung der Erfindung ist die Sensorelektronik dazu eingerichtet, die Kommunikationsschnittstelle direkt zu veranlassen, ein Fehlersignal auszugeben, wenn eine von der Sensorelektronik zu überwachende und von der Logikeinheit einzuhaltende Zeitspanne nicht eingehalten wird.

In einer Weiterbildung der Erfindung ist die Sensorelektronik dazu eingerichtet den von der Logikeinheit bereitgestellten Kontroll-Messwert aus einem Register auszulesen, und nach dem Auslesen des Kontroll-Messwerts aus dem Register einen Fehlerwert in das Register zu schreiben, der außerhalb des Wertevorrats aller möglichen Kontroll-Messwerte liegt, wobei die Logikeinheit dazu eingerichtet ist, den Fehlerwert bei ordnungsgemäßer Funktion mit dem nächsten Kontroll-Messwert zu überschreiben, bevor die Sensor Elektronik das nächste Mal das Register ausliest.

In einer Weiterbildung der Erfindung ist die Sensorelektronik dazu eingerichtet, den von der Logikeinheit bereitgestellten Kontroll-Messwert aus einem Register auszulesen, und nach dem Auslesen des Kontroll-Messwerts aus dem Register einen Fehlerwert in das Register zu schreiben, der außerhalb des Wertevorrats aller plausiblen Kontroll-Messwerte liegt, wobei die Logikeinheit dazu eingerichtet ist, den Fehlerwert bei ordnungsgemäßer Funktion mit dem nächsten Kontroll-Messwert zu überschreiben, bevor die Sensor Elektronik das nächste Mal das Register ausliest.

In einer Weiterbildung der Erfindung ist die Sensorelektronik dazu eingerichtet, die digitalisierten Sensorsignale, auf deren Basis die Sensor-Messwerte berechnet werden, als Fehlerwert in das Register zu schreiben, um damit der Logikeinheit die digitalisierten Signale zur Ermittlung des Kontroll-Messwertes in dem Register bereitzustellen, wobei die Logikeinheit dazu eingerichtet ist, die gleichzeitig als Fehlerwert dienenden digitalisierten Sensorsignale bei ordnungsgemäßer Funktion mit dem nächsten auf Basis der digitalisierten Sensorsignale ermittelten Kontroll-Messwert zu überschreiben.

Der erfindungsgemäße Messumformer kann insbesondere ein Druckmessumformer, ein Durchflussmessumformer ein Füllstands Messumformer, ein Temperatur-Messumformer, ein pH-Messumformer ein Leitfähigkeit-Messumformer ein Dichte-Messumformer ein Zähigkeit-Messumformer oder ein Messumformer für eine andere Prozessmessgröße sein. Die Kommunikationsschnittstelle des Messumformers kann insbesondere eine Schnittstelle mit einem Stromausgang zwischen 4 und 20 mA als Signalstrom für die Ausgabe des Messwerts mit einem Fehlerstrom außerhalb dieses Wertebereichs umfassen, wobei dem analogen Stromsignal ein Digitalsignal nach dem HART-Standard aufmoduliert sein kann. Grundsätzlich kann die Kommunikationsschnittstelle aber auch anderen Standards genügen, beispielsweise dem Profibus-Standard oder dem Foundation-Fieldbus-Standard.

Das Sensormodul kann insbesondere ein erstes Gehäuse aufweisen, in welchem die Sensorelektronik angeordnet ist, wobei das Hauptelektronikmodul ein zweites Gehäuse aufweist, in welchem die Logikeinheit und die Kommunikationsschnittstelle angeordnet sind.

Die Erfindung wird nun anhand des in der Zeichnung dargestellten Ausführungsbeispiels eines erfindungsgemäßen Messumformers erläutert. Es zeigt:

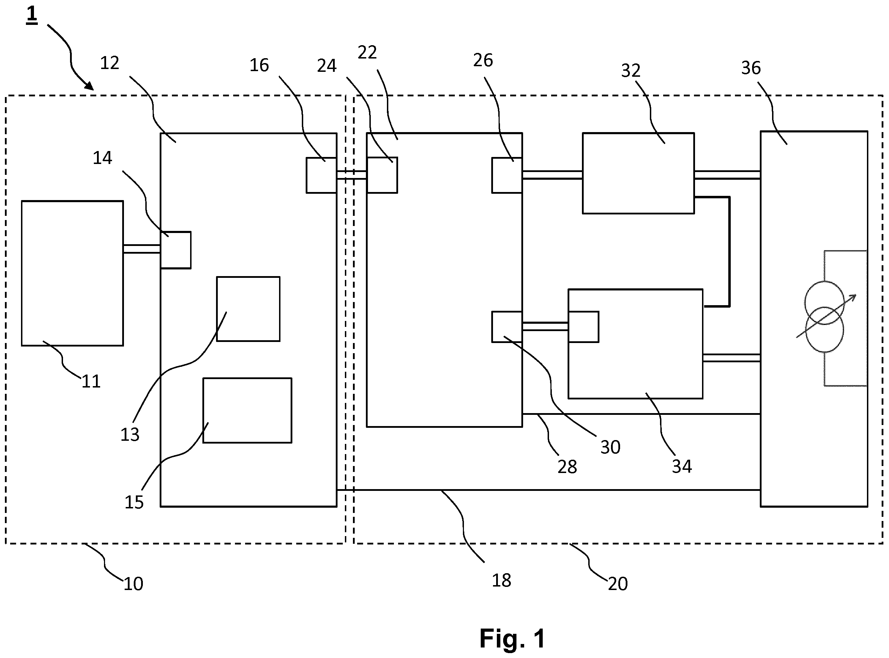

- Fig. 1:: ein schematisches Blockdiagramm eines Ausführungsbeispiels eines erfindungsgemäßen Messumformers

Der in Fig. 1 dargestellte Messumformer 1 umfasst ein Sensormodul 10 und ein Hauptelektronik-Modul 20, die miteinander über zueinander komplementäre digitale Kommunikationsschnittstellen 16, 24 verbunden sind.

Das Sensormodul 10 umfasst einen Sensorelement 11, beispielsweise einen Drucksensor mit einem kapazitiven oder resistiven Druckmesswandler, und eine Sensorelektronik 12, beispielsweise in Form eines ASICs, wobei Primärsignale des Druckmesswandlers an einen analogen Sensoreingang 14 der Sensorelektronik 12 empfangen und im Anschluss daran von der Sensorelektronik digitalisiert und mit einer Übertragungsfunktion aufbereitet werden, wobei die Aufbereitung mit der Übertragungsfunktion einen Algorithmus eines digitalen Signalprozessors DSP umfasst, um einen digitalen Sensor-Messwert an einer ersten digitalen Kommunikationsschnittstelle 16 bereitzustellen.

Das Hauptelektronik-Modul 20 umfasst eine Logikeinheit 22, z.B. einen Mikrokontroller, einen Stromregler 32, ein HART-Modem 34 und eine Stromsenke 36. Die Logikeinheit 22 umfasst eine zweite digitale Kommunikationsschnittstelle 24, welche mit der ersten digitalen Kommunikationsschnittstelle 16 kommuniziert. Über diese digitale Kommunikationsschnittstelle wird beispielsweise im normalen Messbetrieb der digitale Sensor-Messwert übertragen, und die Logikeinheit 22 veranlasst den Stromregler 32 über eine dritte digitale Kommunikationsschnittstelle 26, die Stromsenke 36 so zu regeln, dass sie ein analoges Stromsignal stellt, welches den digitalen Sensor-Messwert oder eine davon abgeleitete Messgröße repräsentiert. Weiterhin umfasst die Logikeinheit 22 eine vierte digitale Kommunikationsschnittstelle 30, über welche das HART-Modem angesteuert wird, um dem analogen Stromsignal digitale Informationen aufzumodulieren, beispielsweise Statusinformationen. Schließlich umfasst die Logikeinheit 22 einen Alarmausgang 28, der direkt auf die Stromsenke 36 durchgreift, um Letztere ohne Einbeziehung des Stromreglers 32 dazu zu veranlassen, einen Fehlerstrom zu stellen.

Die Logikeinheit 22 ist weiterhin dazu eingerichtet, die korrekte Signalaufbereitung mittels der Übertragungsfunktion durch die Sensorelektronik 12 zu überwachen. Zu diesem Zweck werden periodisch, beispielsweise alle 100-1000 Messzyklen nicht nur die aktuellen digitalen Sensor-Messwerte sondern auch die zu diesen Sensor-Messwerten gehörigen digitalisierten Primärsignale von der Sensorelektronik über die zweite digitale Kommunikationsschnittstelle angefordert und ausgelesen. Die von der Sensorelektronik bereitgestellten, digitalen Sensor-Messwerte werden zunächst abgespeichert, dann werden von der CPU der Logikeinheit 22 mittels eines Algorithmus, welcher die von der Sensorelektronik verwendete Übertragungsfunktion umfasst, anhand der ausgelesenen digitalisierten Primärsignale Kontroll-Messwerte berechnet, welche jeweils mit den abgespeicherten Sensor-Messwerten verglichen werden, wobei die Logikeinheit 22 dazu eingerichtet ist bei einer Abweichung über die dritte Kommunikationsschnittstelle 26 oder über den Alarmausgang 28 das Stellen eines Fehlerstroms zu veranlassen.

Der erfindungsgemäße Messumformer 1 bietet weiterhin die Möglichkeit, den Mikrocontroller 22 hinsichtlich seiner Funktionsfähigkeit zu überwachen. Dazu ist vorgesehen, dass die Logikeinheit 22 die errechneten Kontroll-Messwerte der zweiten digitalen Schnittstelle 24 bereitzustellen, so dass die Sensorelektronik 12 sie auslesen kann. Die Sensorelektronik vergleicht dann die Sensor-Messwerte mit den errechneten Kontroll-Messwerten, und veranlasst bei festgestellten Abweichungen über einen Alarmausgang 18 die Stromsenke 36 direkt, also unter Umgehung der Logikeinheit 22, einen Fehlerstrom zu stellen.

Mit dieser Überwachung der Logikeinheit 22 durch die Sensorelektronik werden zumindest all jene Operationen der Logikeinheit überwacht, die zwingend zur Berechnung der Kontroll-Messwerte erforderlich sind.

Es besteht jedoch die Möglichkeit die der Überwachung der Logikeinheit 22 um Operationen zu erweitern, die eigentlich nicht zum Nachrechnen der Übertragungsfunktion erforderlich sind. Wenn beispielsweise arithmetische Operationen, wie eine Multiplikation, beim Berechnen der Übertragungsfunktion nicht vorkommen, so kann die Logikeinheit ein Endergebnis oder einen Zwischenwert mit einem beliebigen Faktor multiplizieren und anschließend durch diesen Faktor dividieren. Dies sollte bei korrekter Arbeitsweise der Logikeinheit hinsichtlich der Multiplikation und der Division keine Veränderung des Endergebnisses der Berechnung bewirken, sofern mögliche Überläufe beachtet werden. Das gleiche gilt entsprechend hinsichtlich anderer arithmetische Operationen und ihrer Inversen. Gleichermaßen kann die Schreib- und Lesefunktion der Logikeinheit 22 getestet werden, indem zunächst einen Wert in einen Speicher geschrieben wird, um ihn anschließend auszulesen und weiter zu verarbeiten. Gleichermaßen können Sprünge in andere Routinen, die zu überprüfen sind, vorgesehen sein solange bei ordnungsgemäßer Arbeitsweise der Logikeinheit die Rückkehr in die Berechnung und Bereitstellung des Kontroll-Messwerts gewährleistet ist.

Auf diese Weise können beliebige Operationen aus dem Befehlsvorrat der Logikeinheit 22 in die Testfunktion mit eingebunden werden, die eigentlich nichts mit der Berechnung eines Kontroll-Messwerts zu tun haben, aber bei fehlerhafter Arbeitsweise dennoch zu einer Veränderung des Kontroll-Messwerts führen, oder einen Abbruch der Berechnung des Kontroll- Messwerts bewirken. Dieses wird von der Sensorelektronik durch einfachen Wertevergleich erkannt und resultiert letztlich in der Ausgabe eines Fehlersignals.

Die Sensor Elektronik 12 kann weiter dazu eingerichtet sein, die Arbeitsweise der Logikeinheit 22 in zeitlicher Hinsicht zu überwachen. So kann die Logikeinheit 22 dazu eingerichtet sein die Durchführung der Überwachungsfunktion in bestimmten zeitlichen Abständen zu veranlassen, wozu er beispielsweise von der Sensorelektronik 12 ein Wertetupel anfordert, welches zusätzlich zum üblichen digitalen Sensor-Messwert noch die digitalisierten Sensorsignale enthält. Die Sensor Elektronik kann die Zeit überwachen, die seit der letzten Anforderung vergangen ist und einen Alarm über den Alarmausgang 18 auslösen, wenn ein Grenzwert für diese Zeit überschritten ist.

Weiterhin kann die Sensor Elektronik die Zeit überwachen, welche die Logikeinheit benötigt um anhand der bereitgestellten digitalisierten Sensorsignale Kontroll-Messwerte zu berechnen. Sollte die Sensorelektronik 12 feststellen, dass die benötigte Zeit einen dafür vorgegebenen Grenzwert überschreitet, kann die Sensorelektronik 12 ebenfalls über den Alarmausgang 18 das Stellen eines Fehlerstromes veranlassen. Schließlich ist es denkbar, dass ein Sensorelement für einen bestimmten Zeitraum mehrmals in Folge die gleichen Primärsignale ausgibt. In diesem Falle würde die Überwachung der Logikeinheit 22 durch die Sensorelektronik 12 versagen, wenn die Logikeinheit 22 keine aktualisierten Kontroll-Messwerte bereitstellt, denn der letzte bereitgestellte Kontroll-Messwert wäre möglicherweise immer noch korrekt. Um diese Fehlerquelle zu vermeiden kann die Sensorelektronik dazu eingerichtet sein, nach dem Auslesen eines zuletzt durch die Logikeinheit bereitgestellten Kontroll-Messwerts aus einem Register, einen solchen Wert in das Register zu schreiben, der außerhalb des Wertevorrats aller plausiblen Kontroll-Messwerte liegt. Wenn dieser Wert dann bei der nächsten Durchführung der Überwachungsfunktion nicht überschrieben wird, ist offensichtlich dass ein Fehler vorliegt, was von der Sensorelektronik 12 durch den vorgesehenen Wertevergleich erkannt und über den Alarmausgang 18 signalisiert wird.

### Bezugszeichenliste

- 1: Messumformer
- 10: Sensormodul
- 11: Sensorelement
- 12: Sensorelektronik
- 13: digitaler Signalprozessor (DSP)
- 14: Kommunikationsschnittstelle
- 15: Speicher
- 16: Kommunikationsschnittstelle
- 18: Alarmausgang
- 20: HauptelektronikModul
- 22: Logikeinheit
- 24: Kommunikationsschnittstelle
- 26: Kommunikationsschnittstelle
- 28: Alarmausgang
- 30: Kommunikationsschnittstelle
- 32: Stromregler
- 34: HART-Modem
- 36: Stromsenke

## Patentansprüche

1. Messumformer (1), umfassend:
ein Sensormodul (10), welches mindestens einen Sensor (11) und eine Sensorelektronik (12) aufweist, wobei der Sensor (11) Sensorsignale ausgibt, und wobei die Sensorelektronik die digitalisierten Sensorsignale mit einer Übertragungsfunktion aufbereitet und aufbereitete Sensor-Messwerte an einer digitalen Schnittstelle bereitstellt; und
ein Hauptelektronikmodul (20), welches mit der Sensorelektronik funktionell verbunden ist, wobei das Hauptelektronikmodul eine Logikeinheit (22) und eine Kommunikationsschnittstelle (36) aufweist, wobei die Logikeinheit (22) dazu eingerichtet ist, die an der digitalen Schnittstelle bereitgestellten Sensor-Messwerte zu empfangen und die Ausgabe eines Messsignals, welches den Sensor-Messwerten entspricht durch die Kommunikationsschnittstelle (36) zu veranlassen, wobei die Logikeinheit dazu eingerichtet ist, eine Überwachungsfunktion auszuführen wobei die Überwachungsfunktion umfasst, zusätzlich zu einem aktuell bereitgestellten Sensor-Messwert die zugehörigen digitalisierten Sensorsignale zu empfangen, anhand einer Testfunktion, welche die Übertragungsfunktion umfasst, und anhand der empfangenen zugehörigen digitalisierten Sensorsignale einen Kontroll-Messwert zu berechnen, und einen Vergleich zwischen dem Kontroll-Messwert und dem Sensor-Messwert durchzuführen, und bei Abweichungen die Kommunikationsschnittstelle zu veranlassen, ein Fehlersignal auszugeben
wobei die Logikeinheit weiter dazu eingerichtet ist den Kontroll-Messwert der Sensorelektronik (12) bereitzustellen, wobei die Sensorelektronik (12) dazu eingerichtet ist, einen Vergleich zwischen dem Kontroll-Messwert und dem Sensor-Messwert durchzuführen, und bei Abweichungen die Kommunikationsschnittstelle (36) über einen Alarmausgang (18) direkt zu veranlassen, ein Fehlersignal auszugeben

2. Messumformer nach Anspruch 1, wobei die Übertragungsfunktion einen Algorithmus umfasst, der dazu eingerichtet ist, Querempfindlichkeiten des Sensors auf Störgrößen zu kompensieren und/oder eine lineare Sensor-Messwert-Funktion bereitzustellen.

3. Messumformer nach Anspruch 1 oder 2, wobei die Testfunktion einen Testalgorithmus umfasst, der zusätzlich zu einer Implementierung der Übertragungsfunktion noch weitere Schritte enthält, wobei der Testalgorithmus zu jedem weiteren Schritt den inversen Schritt umfasst, so dass der Kontroll-Messwert durch die weiteren Schritte bei korrekter Ablauf des Testalgorithmus und bei korrekter Funktion der Logikeinheit im Ergebnis nicht verändert wird.

4. Messumformer nach Anspruch 3, wobei die weiteren Schritte arithmetische Operationen, jeweils in Kombination mit einer zu dieser inversen Operation umfassen.

5. Messumformer nach Anspruch 3 oder 4, wobei die weiteren Schritte Verweise bzw. Sprünge aus dem Algorithmus der Übertragungsfunktion heraus und zurück umfassen.

6. Messumformer nach einem der vorhergehenden Ansprüche, wobei die Sensorelektronik dazu eingerichtet ist, die Sensor-Messwerte mit einer definierten Ausgaberate an der digitalen Schnittstelle bereitzustellen, wobei die Logikeinheit dazu eingerichtet ist zu überwachen, ob die Ausgaberaten eingehalten wird, und die Kommunikationsschnittstelle zu veranlassen, ein Fehlersignal auszugeben, wenn dies nicht der Fall ist.

7. Messumformer nach einem der vorhergehenden Ansprüche, wobei die Überwachungsfunktion in definierten zeitlichen Abständen durchzuführen ist, wobei die Durchführung der Überwachungsfunktion durch die Logikeinheit zu initiieren ist, wobei die Sensorelektronik überwacht, ob der zeitliche Abstand zum Initiieren der Überwachungsfunktion eingehalten wird.

8. Messumformer nach einem der vorhergehenden Ansprüche, wobei die Logikeinheit dazu eingerichtet ist, den Kontroll-Messwert innerhalb einer vorgegebenen Bearbeitungszeit nach dem Empfang der digitalisierten Sensorsignale bereitzustellen, wobei die Sensorelektronik dazu eingerichtet ist zu überwachen, ob die vorgegebene Bearbeitungszeit eingehalten wird.

9. Messumformer nach einem der vorhergehenden Ansprüche, wobei die Sensorelektronik dazu eingerichtet ist, die Kommunikationsschnittstelle direkt zu veranlassen, ein Fehlersignal auszugeben, wenn eine von der Sensorelektronik zu überwachende und von der Logikeinheit einzuhaltende Zeitspanne nicht eingehalten wird.

10. Messumformer nach einem der vorhergehenden Ansprüche, wobei die Sensorelektronik dazu eingerichtet ist den von der Logikeinheit bereitgestellten Kontroll-Messwert aus einem Register auszulesen, und nach dem Auslesen des Kontroll-Messwerts aus dem Register einen Fehlerwert in das Register zu schreiben, der außerhalb des Wertevorrats aller plausiblen Kontroll-Messwerte liegt, wobei die Logikeinheit dazu eingerichtet ist, den Fehlerwert bei ordnungsgemäßer Funktion mit dem nächsten Kontroll-Messwert zu überschreiben, bevor die Sensor Elektronik das nächste Mal das Register ausliest.

11. Messumformer nach Anspruch, 10, wobei die Sensoreinheit dazu eingerichtet ist die digitalisierten Sensorsignale, auf deren Basis die Sensor-Messwerte berechnet werden, als Fehlerwert in das Register zu schreiben, um damit der Logikeinheit die digitalisierten Signale zur Ermittlung des Kontroll-Messwertes in dem Register bereitzustellen, wobei die Logikeinheit dazu eingerichtet ist, die gleichzeitig als Fehlerwert dienenden digitalisierten Sensorsignale bei ordnungsgemäßer Funktion mit dem nächsten auf Basis der digitalisierten Sensorsignale ermittelten Kontroll-Messwert zu überschreiben.

## Claims

1. Transmitter (1), comprising :
a sensor module (10), having at least one sensor (11) and one sensor electronics system (12), wherein the sensor (11) outputs sensor signals and wherein the sensor electronics system treats the digitalized sensor signals with a transmission function and makes treated sensor measured values available at a digital interface; and
a main electronics module (20), which is functionally connected to the sensor electronics system, wherein the main electronics module has a logic unit (22) and a communication interface (36), wherein the logic unit (22) is configured to receive the sensor measured values provided at the digital interface and to order the outputting of a measuring signal, which corresponds to the sensor measured values, via the communication interface (36), wherein the logic unit is configured to perform a monitoring function, wherein, in addition to receiving the sensor measured value currently provided, said monitoring function also consists of receiving the associated digitalized sensor signals, of calculating a control measured value using both a test function, which comprises the transmission function, and the associated digitalized sensor signals received, of performing a comparison between the control measured value and the sensor measured value and of ordering the communication interface to output an error signal in the event of deviations,
wherein the logic unit is further configured to provide the control measured value to the sensor electronics system (12), wherein the sensor electronics system (12) is configured to perform a comparison between the control measured value and the sensor measured value and, in the event of deviations, to directly order the communication interface (36) to output an error signal via an alarm output (18).

2. Transmitter as claimed in Claim 1, wherein the transmission function comprises an algorithm, which is configured to compensate for sensor cross-sensitivity to interference variables and/or provide a linear sensor measured value function.

3. Transmitter as claimed in Claim 1 or 2, wherein the test function comprises a test algorithm, which, in addition to the implementation of the transmission function, contains additional steps, wherein the test algorithm constitutes the inverse step for every additional step, such that, in terms of the result, the control measured value is not modified by the additional steps if the test algorithm runs correctly and if the logic unit works correctly.

4. Transmitter as claimed in Claim 3, wherein the additional steps comprise arithmetic operations, each in combination with an operation inverse to said operation.

5. Transmitter as claimed in Claim 3 or 4, wherein the additional steps comprise references and jumps from and to the algorithm of the transmission function.

6. Transmitter as claimed in one of the previous claims, wherein the sensor electronics system is designed to provide the sensor measured values at the digital interface at a defined output rate, wherein the logic unit is designed to monitor whether the output rates are observed and to order the communication interface to output an error signal if this is not the case.

7. Transmitter as claimed in one of the previous claims, wherein the monitoring function is to be performed at defined intervals, wherein the logic unit is to initiate the performance of the monitoring function, wherein the sensor electronics monitor whether the interval for initiating the monitoring function is observed.

8. Transmitter as claimed in one of the previous claims, wherein the logic unit is configured to provide the control measured value within a predefined processing time following the receipt of the digitalized sensor signals, wherein the sensor electronics system is configured to monitor whether the predefined processing time is observed.

9. Transmitter as claimed in one of the previous claims, wherein the sensor electronics system is configured to directly order the communication interface to output an error signal if a time frame to be monitored by the sensor electronics and to be observed by the logic unit is not observed.

10. Transmitter as claimed in one of the previous claims, wherein
the sensor electronics system is configured to read the control measured value, provided by the logic unit, out of a register, and, once the control measured value has been read out of the register, to write an error value into the register, said value being outside the domain of all plausible control measured values, wherein, when functioning correctly, the logic unit is configured to overwrite the error value with the next control value before the next time the sensor electronics read out the register.

11. Transmitter as claimed in Claim 10,
wherein the sensor unit is configured to write the digitalized sensor signals - on the basis of which the sensor measured values are calculated - to the register as an error value in order to provide the logic unit with the digitalized signals for determining the control measured value in the register, wherein the logic unit is configured to overwrite the digitalized sensor signals, which also serve as an error value, with the next control measured value determined on the basis of the digitalized sensor signals when the unit is functioning correctly.

## Revendications

1. Transducteur (1), comprenant :
un module capteur (10), lequel comprend au moins un capteur (11) et une électronique de capteur (12), le capteur (11) délivrant des signaux de capteur et l'électronique de capteur traitant les signaux de capteur numérisés avec une fonction de transmission et mettant à disposition les valeurs mesurées de capteur traitées à une interface numérique ; et
un module électronique principal (20), lequel est relié de manière fonctionnelle avec l'électronique de capteur, le module électronique de capteur comportant une unité logique (22) et une interface de communication (36), l'unité logique (22) étant configurée de telle sorte à recevoir les valeurs mesurées de capteur mises à disposition sur l'interface numérique et à ordonner via l'interface de communication (36) la sortie d'un signal de mesure, qui correspond aux valeurs mesurées de capteur, l'unité logique étant configurée à exécuter une fonction de surveillance, la fonction de surveillance consistant
à recevoir, outre une valeur mesurée de capteur actuellement mise à disposition, les signaux de capteur numérisés,
à calculer une valeur mesurée de contrôle au moyen d'une fonction de test, laquelle comprend la fonction de transmission, et au moyen des signaux de capteur numérisés correspondants reçus,
et à effectuer une comparaison entre la valeur mesurée de contrôle et la valeur mesurée de capteur,
et, en cas d'écarts, à ordonner à l'interface de communication à émettre un signal d'erreur
pour lequel l'unité logique est en outre configurée de telle sorte à mettre à disposition de l'électronique de capteur (12) la valeur mesurée de contrôle, l'électronique de capteur (12) étant configurée de telle sorte à effectuer une comparaison entre la valeur mesurée de contrôle et la valeur mesurée de capteur et, en cas d'écarts, à ordonner directement à l'interface de communication (36) à émettre un signal d'erreur via une sortie alarme (18).

2. Transducteur selon la revendication 1, pour lequel la fonction de transmission comprend un algorithme, qui est défini de telle sorte à compenser les sensibilités transversales du capteur aux grandeurs perturbatrices et/ou à mettre à disposition une fonction linéaire de valeurs mesurées de capteur.

3. Transducteur selon la revendication 1 ou 2, pour lequel la fonction de test comprend un algorithme de test, qui contient en plus d'une implémentation de la fonction de transmission encore d'autre étapes, l'algorithme de test comprenant pour chaque étape supplémentaire l'étape inverse, si bien que la valeur mesurée de contrôle n'est pas modifiée en terme de résultat par les autres étapes en cas de déroulement correct de l'algorithme de test et en cas de fonctionnement correct de l'unité logique.

4. Transducteur selon la revendication 3, pour lequel les étapes supplémentaires comprennent des opérations arithmétiques, respectivement en combinaison avec une opération inverse par rapport à celles-ci.

5. Transducteur selon la revendication 3 ou 4, pour lequel les étapes supplémentaires comprennent des renvois ou des sauts à partir et vers l'algorithme de la fonction de transmission.

6. Transducteur selon l'une des revendications précédentes,
pour lequel l'électronique de capteur est configurée de telle sorte à mettre à disposition de l'interface numérique les valeurs mesurées de capteur selon une cadence de sortie définie,
pour lequel l'unité logique est configurée de telle sorte à surveiller que la cadence de sortie est respectée, et à ce que l'interface de communication ordonne l'émission d'un signal d'erreur, si ce n'est pas le cas.

7. Transducteur selon l'une des revendications précédentes, pour lequel la fonction de surveillance doit être exécutée selon des intervalles de temps définis, l'exécution de la fonction de surveillance devant être déclenchée par l'unité logique, l'électronique de capteur surveillant si l'intervalle de temps pour le déclenchement de la fonction de surveillance est respecté.

8. Transducteur selon l'une des revendications précédentes,
pour lequel l'unité logique est configurée de telle sorte à mettre à disposition la valeur mesurée de contrôle au sein du temps de traitement prédéfini après la réception des signaux de capteur numérisés,
pour lequel l'électronique de capteur est configurée de telle sorte à surveiller que le temps de traitement prédéfini est respecté.

9. Transducteur selon l'une des revendications précédentes, pour lequel l'électronique de capteur est configurée de telle sorte que l'interface de communication ordonne directement l'émission d'un signal d'erreur lorsque l'intervalle de temps, devant être surveillé par l'électronique de capteur et respecté par l'unité logique, n'est pas respecté.

10. Transducteur selon l'une des revendications précédentes,
pour lequel l'électronique de capteur est configurée de telle sorte à lire à partir d'un registre la valeur mesurée de contrôle mise à disposition par l'unité logique et, après la lecture à partir du registre de la valeur mesurée de contrôle, à écrire une valeur d'erreur dans le registre, qui se situe en dehors de la réserve de valeurs de l'ensemble des valeurs mesurées de contrôle plausibles,
pour lequel l'unité logique est configurée de telle sorte à écraser la valeur d'erreur en cas de fonctionnement correct avec la valeur mesurée de contrôle suivante, avant la prochaine lecture du registre par l'électronique de capteur.

11. Transducteur selon la revendication 10,
pour lequel l'unité de capteur est configurée de telle sorte à écrire en tant que valeur d'erreur dans le registre les signaux de capteur numérisés, sur la base desquels les valeurs mesurées de capteur sont calculées, afin de mettre à la disposition de l'unité logique les signaux numérisés en vue de la détermination de la valeur mesurée de contrôle dans le registre,
pour lequel l'unité logique est configurée de telle sorte à écraser les signaux de capteur numérisés, servant en même temps de valeur d'erreur, en cas de fonctionnement correct, avec la valeur mesurée de contrôle suivante, déterminée sur la base des signaux de capteur numérisés.
